(19) Europäisches Patentamt

European Patent Office

Office européen des brevets

(11) Publication number: 0 341 851 A2

# (12) EUROPEAN PATENT APPLICATION

(21) Application number: 89304047.7

(22) Date of filing: 24.04.89

(51) Int. Cl.⁴: H03M 13/00 , H03M 13/22

(30) Priority: 12.05.88 US 193380

(43) Date of publication of application:
15.11.89 Bulletin 89/46

(84) Designated Contracting States:
DE FR GB IT NL

(71) Applicant: DIGITAL EQUIPMENT
CORPORATION
146 Main Street
Maynard, MA 01754-1418(US)

(72) Inventor: Weng, Lih-Jyh
6, Bicentennial Drive
Lexington Massachusetts 02173(US)

(74) Representative: Goodman, Christopher et al
Eric Potter & Clarkson 14 Oxford Street
Nottingham NG1 5BP(GB)

(54) Method and apparatus for interleaved encoding.

(57) An apparatus and method for interleaved encoding data symbols into code words using a Reed-Solomon error correction code. The invention finds particular utility for the recovery of computer data stored on mass storage media, such as disks.

FIG. 1

# METHOD AND APPARATUS FOR INTERLEAVED ENCODING

## RELATED APPLICATIONS

The subject matter of this application is related to that of U.S. Patent No. (Serial No. 047,627, filed May 7, 1987) entitled "Error Correction Code Encoder".

## FIELD OF THE INVENTION

The invention relates to digital processing systems, and more particularly to a method and apparatus for encoding data so as to form an error correction code useful in the accurate recovery of stored data from mass storage devices.

## BACKGROUND OF THE INVENTION

The importance of error correction coding of data in digital processing systems has increased greatly as the density of the data recorded on mass storage media, more particularly disks, has increased. With higher recording densities, a tiny imperfection in the recording surface of a disk can corrupt the recorded data. In order to avoid losing that data, error correction codes ("ECC's") are employed, as the name implies, to correct the erroneous data.

Before a string of data symbols is written to a disk, it is mathematically encoded to form ECC symbols. The ECC symbols are then appended to the information or data string to form code words - data symbols plus ECC symbols - of "n" symbols in length, which can then be written to the disk for storage. Such code words are described as being "systematic" , that is, its first "k" symbols are a replica of the data string and the remaining "n-k" symbols are redundancy or parity checks for the k data symbols. That can be expressed mathematically as $n = k + R$, where "R" is the number of redundancy or parity check symbols.

When data is to be read from the disk, the code words containing the data symbols to be read are retrieved from the disk and mathematically decoded. During decoding any errors in the data are detected and, if possible, corrected through manipulation of the ECC symbols pursuant to a correction algorithm. Essentially, for error detection, the retrieved data string is re-encoded so as to form a second ECC. The second ECC is then compared with the initially generated and stored ECC to detect any errors. If any errors are detected, they are located and corrected by applying the correction algorithm to the ECC comparison.

[For a detailed description of the principles of data encoding and decoding see Peterson and Weldon, Error Correction Codes, 2d Edition, MIT Press, 1972].

Stored digital data can contain multiple independent errors. One type of ECC used for the correction of multiple errors is a Reed-Solomon code. To correct multiple errors in strings of data symbols, Reed-Solomon codes efficiently and effectively utilize the various mathematical properties of sets of symbols known as Galois Fields, represented "$GF(P^q)$", where "P" is a prime number and "q" can be thought of as the number of digits, base P, in each element or symbol in the field. "P" usually has a value of two in digital computer applications and, therefore, "q" is the number of bits in each symbol.

The number of symbols that an ECC based on a Reed-Solomon code can effectively encode and correct, or "protect", is limited by the size of the Galois Field selected, i.e., "$p^q$" symbols, and the maximum number of errors which the code is to be capable of correcting. The maximum length, "$n_{max}$", of a cyclic Reed-Solomon code word for $GF(P^q)$ is "$P^q-1$" symbols. Thus, the maximum number of data symbols which can be protected by the ECC, and accommodated in the code word, is "$P^q-1-R$", where "R" is the number of ECC symbols.

The larger the Galois Field, the longer the code word, and the more data which the ECC can protect for a given maximum number of errors to be corrected. Therefore, larger Galois Fields could be used to protect longer strings of data symbols. However, using Galois Fields that neither result in 8-bit code word symbols, nor symbols that contain a number of bits which are multiples of eight, complicates the circuitry of the system, since most systems are configured to handle data in strings of that length. Therefore, if code words of other lengths are used, changes in hardware are necessary, or mathematical manipulation is required to transform the code word into one of acceptable length, as discussed in U.S. Patent , cited above.

Galois Field $GF(2^8)$ is a preferred size, resulting in 8-bit ECC symbols. An ECC based on $GF(2^8)$ can protect a string of up to 253 8-bit data symbols (bytes) against a single error, using two 8-bit ECC symbols which are typically appended to the data. If the ECC is to correct more than one error, more ECC symbols (typically two for each additional error to be corrected) must be used in the code word. This means that fewer data bytes can be protected for a given, fixed length of code word. Moreover, information is often stored on magnetic disks in sectors which are, 512 or 576 bytes in length. Therefore, ECC's which are based on GF($2^8$) cannot, without further manipulation of the code, protect an entire sector.

A technique used to protect an entire 512 or 576 byte sector with a GF($2^8$) ECC entails dividing the sector into multiple, interleaved strings of symbols (bytes). Known interleaving techniques effectively split the string of data symbols into several smaller segments or blocks, and treat each segment as a stream of data symbols to be encoded. Among the benefits of interleaving are that (i) it permits a larger number of data symbols to be encoded by a given code, and (ii) it effectively spreads or diffuses bursts of errors by including adjacent data symbols in different data strings, each string being encoded into its own code word.

Mathematically speaking, typical interleaved codes are obtained by arranging "i" code words of the original code into "L" rows of a rectangular array or matrix that is stored by columns. The parameter "L" is called the interleaving degree of the code, and represents the depth of interleaving. It has significance in several respects. For example, if the original non-interleaved code is capable of correcting up to "t" random errors, the interleaved code will have the same random-error-correction capability, but in addition it will be able to correct error bursts of length equal to or less than the product of L and t by diffusing the burst pattern into isolated errors appearing in various matrix entries.

Practically speaking, in a typical prior art system for encoding and interleaving data strings, the message data is treated as though it were "L" strings of interleaved data. These strings are physically separated and applied to separate encoders to generate a separate set of ECC symbols for each. The original message sequence is recorded on a disk. The sets of ECC's symbols are interleaved and also recorded on the disk. Coming off the disk, the process is repeated. Such an approach requires additional hardware compared with systems not utilizing such an interleaving technique. Alternatively, if the data stream is queued in a suitable buffer, a single encoder device can be used to separately process each interleaved segment, one after the other, in sequential passes through the device at a sacrifice in efficiency.

## SUMMARY OF THE INVENTION

Accordingly, the invention aims to provide an improved encoder for generating an error correction code.

A further object of the invention is to provide an improved encoder capable of single-pass generation of an interleaved code word.

Still another object of the invention is to provide an interleaving encoder requiring less overhead than prior art devices.

It is a more general object of the present invention to provide an improved interleaved encoder which overcomes to some extent the above-mentioned limitations and disadvantages of the prior art.

Other objects of the invention will in part be obvious, and will in part appear hereinafter.

The invention accordingly comprises the features of construction, combination of elements and arrangement of parts which will be exemplified in the following detailed description, and the scope of the invention will be indicated in the appended claims.

Briefly, an encoder embodying the invention is designed similar to prior art non-interleaving encoders except that "L" registers are substituted for each of the prior art registers. The entire interleaved data sequence is applied to the decoder and the decoder operates in an interleaved fashion to generate "L" interleaved sets of ECC symbols for the respective virtual data sequences and thereby achieves ECC interleaving to a depth of "L". An encoder in accordance with the invention therefore achieves the results of prior art arrangements having a separate encoder for each string, and an interleaver which divides the message stream into strings for interleaving. Therefore, a savings is realized in the hardware required for the generation of interleaved ECC'S.

The invention also encompasses a method for interleaved encoding of data symbols into code words of a Reed-Solomon error correction code using a generator polynomial which is expressed as a function of a variable "x". In effect, a modified generator polynomial is computed in which each power of x in the original generator polynomial is multiplied by "L", where "L" is again equal to the depth of interleaving desired. The encoding circuit configured according to the modified generator polynomial has a multiple of "L" registers which serve to virtually interleave the symbols being processed by the encoder, thereby generating an interleaved ECC.

## BRIEF DESCRIPTION OF THE DRAWINGS

For a fuller understanding of the features, advantages, and objects of the invention, reference should be made to the following detailed description and the accompanying drawings, in which:

FIGURE 1 is a functional block diagram of a computer data storage and recovery system incorporating error correction capability in accordance with the invention; and,

FIGURES 2 and 3 are schematic diagrams of interleaved encoding circuits according to alternative embodiments of the invention.

## DETAILED DESCRIPTION OF THE ILLUSTRATIVE EMBODIMENT

### a. General Description

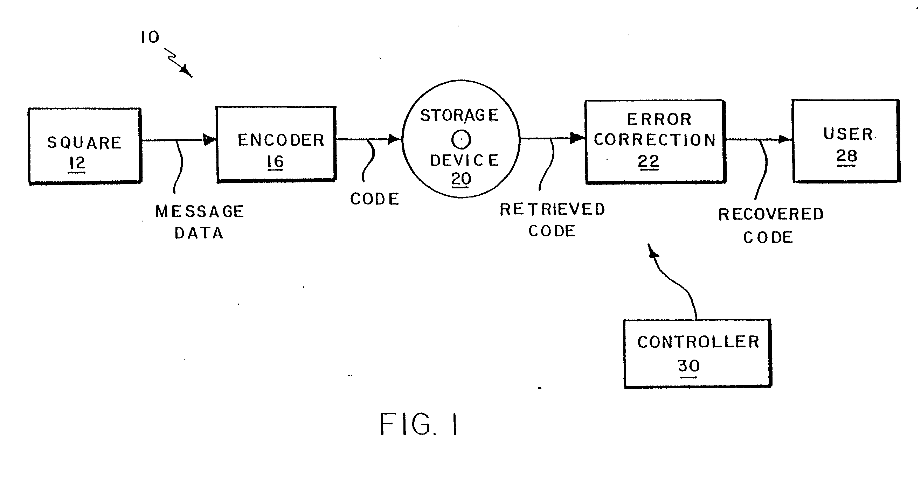

Referring now to the drawings, FIGURE 1 shows a data storage and recovery system 10. The illustrated source 12 supplies a message data stream in binary form to an encoder 16. The encoder 16 converts each data sequence into a code word of length "n". The code words are supplied to a storage device 20 in which, for example, the code words are stored on a disk. For retrieval of the code words from storage and recovery of the message data, an error correcting device 22 obtains the desired code words from the storage device 20. The error correcting device 22 employs an encoder, ordinarily the encoder 16, in detecting errors in the message portion of the retrieved code word, and it employs additional circuitry (not shown) in correcting the errors, thereby accurately recovering the original message data sequence. This is then supplied over a bus to a user 28. The operation and sequencing of the components of the storage system 10 are controlled by a controller 30.

Error detection and correction generally entail the reencoding of the message or data portion of the retrieved code word. This generates a second error correction code (ECC) which is then compared with the initial one from storage. The errors appear as inconsistencies between the two ECC'S, and typically are correctable by known techniques so as to recover the original data sequence in error-free form.

Mathematically speaking, the encoding process according to the invention encodes and interleaves a source or message data sequence into code words using a Reed-Solomon error correction code ("ECC") over a Galois Field "$P^q$". For this, a fixed generator polynomial is used to generate an ECC from the source sequence. The source sequence can be considered a source polynomial which has coefficients corresponding to the Galois Field elements describing the source data stream. In generating the code word, the generator polynomial is used to arithmetically process or operate on (i.e.,

add, subtract, divide or multiply) the source polynomial. The resulting output terms can be appended to the source polynomial to form a systematic code word having coefficients corresponding to both the original message data sequence and the error correction code generated therefor.

The encoder 16 can be implemented in any of several different embodiments according to the invention. From the start, however, it is important to appreciate that the encoding circuits are specially adapted to form interleaved code words. As such, the encoding circuits are arranged and connected in accordance with modified generator polynomials so as to take into account the depth of interleaving desired.

### b. Specific Description

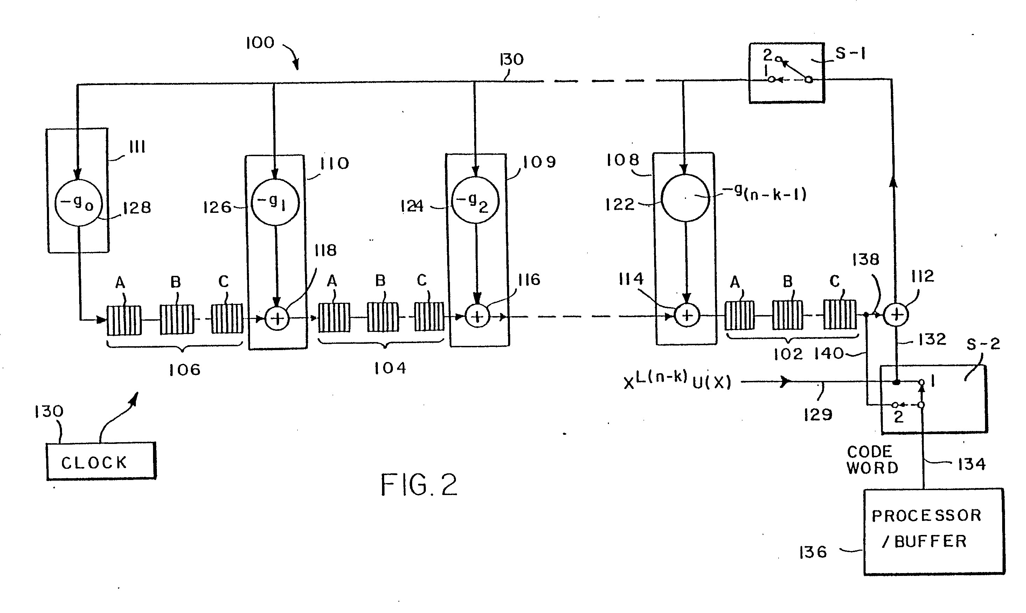

Figure 2 shows an interleaving/encoding circuit 100 for generating an $L^*(n,k)$ code word, i.e, an interleaved systematic code word having a total length "nL" of which "kL" data symbols correspond to the source data sequence, and the ECC is interleaved to a depth "L", where "nL", "kL" and L are positive integers. Circuit 100 is particularly well suited for a high-rate code where the number of message data symbols greatly exceeds the number of ECC symbols. In circuit 100 a message data input in the form $x^{L(n-k)}u(x)$ is arithmetically manipulated the generator polynomial, as next described.

The encoding circuit 100 includes "n-k" or "R" sets of serially-connected, eight-byte (for q = 8) registers of which register sets 102, 104, 106 are shown. The illustrated registers within each set are designated A, B, and C. The circuit 100 also employs arithmetic processing subcircuits 108, 109, 110, 111. The processing subcircuits 108, 109, 110 include adders in the form of EXCLUSIVE-OR gates ("XOR's") 114, 116, 118 for performing modulo two addition/subtraction, and one of a bank of parallel Galois Field multipliers 122, 124, 126, respectively. Arithmetic processing circuit 111 has a multiplier 128.

Each register set 102, 104, 106 constitutes a "shift register". Each register A, B, C within each shift register 102, 104, 106 constitutes a storage or delay device, and can be considered a cell or unit of the shift register. The output of each register A, B, C is the same as the input, but delayed in time, e.g., by one clock unit (a clock is shown at 130.) In accordance with the invention, and as further explained below, the number of registers A, B, C in each set 102, 104, 106 is equal to the desired depth "L" of interleaving. In the illustrated circuit 100, L = 3 and therefore three registers are shown in each shift register 102, 104, 106. Of course, the depth of interleaving can be any practical number equal to or greater than two, depending on the application.

In effect, circuit 100 has a plurality of stages, each stage made up of a processing subcircuit and a shift register. Thus, stage I has processing subcircuit 110 and shift register 106, stage II includes the processing subcrement 109 and shift register 104; and so forth. As illustrated, XOR 112 is situated on the input/output node of circuit 100, and each of the XOR's 114, 116, 118 is connected to receive the output from a stage's shift register and provide the input for the shift register of the next stage. The other input of each of the XOR's is the output of one of the multipliers 122-128.

Consider the simplified case in which a message data of nine symbols (i.e., $K = 9$), is to be protected by an ECC having four symbols ($R = 4$), interleaved to a depth of $L = 3$. A message sequence to be encoded is represented by the symbol string $a_0 b_0 c_0 a_1 b_1 c_1 a_2 b_2 c_2 \ldots a_n b_n$. This message is to be treated as three interleaved strings $a_0 a_1 a_2 \ldots a_n$, $b_0 b_1 b_2 \ldots b_n$ and $c_0 c_1 c_2 \ldots c_n$. Each of these strings is to be encoded using the generator polynomial $g(x)$ given by

$$g(x) = g_0 + g_1 x + g_2 x^2 + \ldots g_{n-k-1} x^{n-k-1} + x^{n-k} \qquad (1)$$

(over $GF(2^8)$, where $-g_i = g_i$)

Three register sets 102, 104, 106 and three multipliers 124 126, 128 are needed, assuming all coefficients in the generator polynomial are non-zero. (The phantom lines indicating a continuation of the circuit 100 along with multiplier 122 can be ignored for purposes of this example.)

After initialization of the shift registers 102-106, e.g., to ZERO, the message to be encoded is serially fed in, a byte at a time, over bus 129 with a switch S-1 initially closed. With a switch S-2 in position (1), the successive symbols of the incoming message are transmitted in both over bus 132 to XOR 112 and over bus 134 to a buffer 136. Buffer 136 stores the message signal as received. In response to pulse from clock 130, symbol $a_0$ is added (module two) with the contents of register 102C, which is ZERO, transmitted over bus 130 to Galois Field multiplier 122-128, and divided by generator polynomial coefficients stored therein, (e.g., $-g_{(n-k-1)}$, $-g_2$, $-g_1$, and $-g_0$). The initial $a_0$ quotients are simultaneously stored in registers 102A, 104A, 106A, (i.e, the left hand registers of each set).

On the next clock pulse, b is introduced and divided. The $b_0$ quotients are stored in registers 102A, 104A, 106A and their former contents, the initial $a_0$ quotients, are shifted to registers 102B, 104B, 106B, respectively. An analogous process occurs for $c_0$, as the $b_0$ terms shift to registers 102B, 104B, 106B. $a_0$ terms shift to registers 102C, 104C, 106C (the right hand registers in the draw-

ing).

As $a_1$ enters circuit 100 and is divided, the initial $a_0$ quotients stored in register 102C is fed over bus 138 to XOR 112 where it is added to the incoming $a_1$. Thus, XOR 112 is part of the circuit's feedback arrangement. The other $a_0$ quotients stored in registers 104C, 106C are fed to XOR's 116, 118 where they are added (modulo two) with the $a_1$ quotients, and then the resulting terms stored in registers 102A, 104A. (Actually, due to the sign of the stored coefficients, the feedback connections accomplish a subtraction of the coefficient quotients from the supplied signals from registers 102C, 104C, 106C).

This process continues while all symbols of the ABC message sequence are inputted, combined at XOR 112 with a feedback term, sent as a signal representing the combination over bus 130 to dividers, etc. After a total of LK shifts (i.e. where 27 shifts, $L = 3$ and $k = 9$) of the shift registers 102, 104, 106, all message symbols have been processed, down to and including c. As such, the polynomial division is complete. The remainder in the shift register constitutes the ECC for the particular message sequence. Then, switches S-1 and S-2 are moved to their positions (2). This results in the signal path over bus 130 being interrupted, and the circuit 100 being ready to transfer the contents of the shift register 102, 104, 106. The contents of the shift register sets 102, 104, 106 can be read in parallel, or as illustrated, serially unloaded through all of the sets 102, 104, 106 as 8-bit ECC symbols which are transmitted over the bus 140. The buffer 136 concatenates the ECC symbols with the message sequence and thereby forms a systematic code word of nL symbols.

It can now be understood that the circuit 100 operates on the message sequence as though it comprised three interleaved strings, $a_0 a_1 \ldots a_n$, $b_0 b_1 \ldots b_n$, $c_0, c_1 \ldots c_n$. Each of these strings is processed separately in forming the ECC. By inspection, it can be seen that by replacing each register in the prior art circuit with "L" registers, the circuit is effectively configured as if the variable in each term of the generator polynomial were raised to the "L" power.

Accordingly, it can be seen that the encoder 16 employs the linear feedback shift register circuit 100 both to perform an encoding function and an interleaving function. This arrangement has a particular advantage over the prior art in that it uses a single encoder for both encoding and residues computing nodes, requiring only a single pass of the message therethrough for generating its ECC. In other words, there is no need to separate the message data into multiple subsets during encoding despite the fact that interleaving is desired. In the prior art this would have meant the use of separate encoders for each subset, or the separate and repeated operation of the same encoder. The same is true with regard to the residues computation node.

(c.) Alternative Embodiments

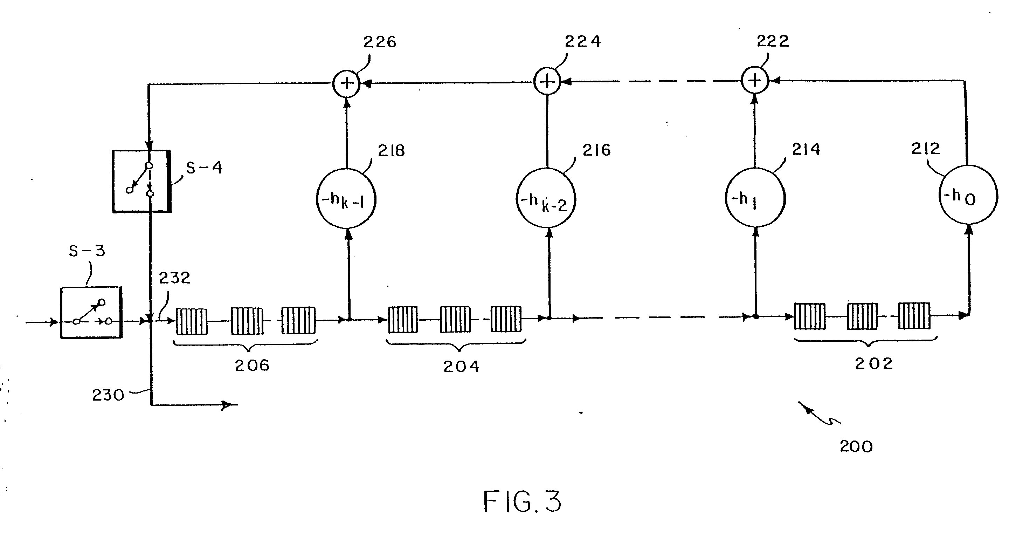

Those skilled in the art will recognize that the invention can be practiced by applying its principles to other encoder circuits. For example, where a low rate code is to be utilized, wherein the number of ECC symbols significantly exceeds the number of data symbols (such as would be the case in header address correction) a multiplication circuit is often preferred. Such a multiplication-type interleaved encoding circuit is shown in FIGURE 3, and designated 200. Circuit 200 generates an L (n,k) code with a serial generator sometimes known as a recursive polynomial h(x) given by

$$h(x) = h_0 \; (+) \; h_1 x \; (+) \; .... \; (+) \; h_{k-1} x^{k-1} \; (+) \; x^k \quad (2)$$

The relationship between g(x) and h(x) is given by

$$g(x) \bullet h(x) = x^n - 1 \quad (3)$$

In circuit 200, the "k" register sets 202, 204, 206 each contain "L" registers (as illustrated, L = 3 and therefore, each shift register has 3 registers, for example).

For encoding, with switches $S_3$, $S_4$ at their positions (1), the register sets 202, 204, 206, are initially loaded with all message data symbols. In other words, and using the message sequence given above, a succession of clock pulses shifts the entire message string. The switches $S_3$, $S_4$ are then switched to their positions (2). Afterwards, on successive clock pulses each register set 202, 204, 206, shifts, feeding the contents of the right-hand registers of each set in parallel to multipliers 212, 214, 216, 218 and to the next register set to the right.

The multipliers 212, 214, 216, 218, multiply their inputs by fixed terms, which for each is the negative of one of the coefficients of h(x). The output from multiplier 212 is fed as an input into XOR 222, and the outputs from multipliers 214, 216, 218, are fed as inputs into XOR's 222, 224, 226, respectively.

The XOR's 222, 224, 226 are interconnected to successively add the outputs of those disposed farther to the right in the drawing to the respective inputs from the multipliers. The output from XOR 226 is fed in parallel over main output bus 230 and feedback bus 232 to shift register 206. This process continues for L(n-k) clock pulses, i.e. until L(n-k) ECC symbols have been transmitted over the output line 230. This ECC output is an interleaved code word as described above in connection with Figure 2.

The foregoing description has been limited to specific embodiments of this invention. It will be apparent, however, that variations and modifications may be made without departing from the spirit of the invention. For example, multiple-input multiplier circuits, or multiplying and dividing circuits can be used to implement the invention.

It is accordingly intended that all matter contained in the above description or shown in the accompanying drawings be interpreted as illustrative rather that restrictive, with the scope of the invention being indicated by the appended claims. All changes which come within the meaning and range of equivalency of the claims are therefore intended to be embraced herein

Claims

1. An encoder for interleaved encoding of "Lk" data symbols, where "L" and "k" are positive integers, using a Reed-Solomon error correction code ("ECC") over a Galois Field which is too small to protect the Lk data symbols without interleaving the ECC, and using a generator polynomial therefor in which each term has a coefficient multiplied by a variable raised to a power, said encoder comprising:
  A. a plurality of arithmetic processing means, each arithmetically manipulating said data symbols by said coefficients of said generator polynomial; and
  B. a plurality of shift registers each including "L" storage units;
  C. wherein said shift registers and said arithmetic processing means are electrically connected in a feedback arrangement in accordance with said generator polynomial.

2. The encoder in accordance with Claim 1, wherein said storage units are connected to successively receive symbols each of which corresponds to one of said data symbols, and said arithmetic processing means combines each said symbol with another symbol corresponding to a data symbol that is "L" symbols away from said one symbol in said data sequence.

FIG. 1

EP 0 341 851 A2

FIG.2

FIG.3